# EUROPEAN PATENT APPLICATION

(11) **EP 4 610 726 A2**
(43) Date of publication of application: **03.09.2025**
(21) Application number: 25155385.5
(22) Date of filing: 31.01.2025
(51) Int. Cl.: G03F 7/00, G03F 7/004, G03F 7/038, G03F 7/039, G03F 7/20

(54) **RESIST COMPOSITION FOR PHOTOLITHOGRAPHY AND METHOD FOR MANUFACTURING SEMICONDUCTOR DEVICES USING THE SAME**

(30) Priority: 02.02.2024 KR 20240016553; 08.01.2025 KR 20250002657
(71) Applicant: Korea University Research and Business Foundation, Seoul 136-701 (KR)
(72) Inventor: LEE, Seungwoo, 136-701 Seoul (KR); KIM, Minsang, Seoul (KR); NOH, Doyeon, Incheon (KR); KIM, Kyeongsoo, Seoul (KR); KIM, Kwangjin, Seoul (KR)
(74) Representative: Marks & Clerk LLP

(57) **Abstract**

Provided are a resist composition for photolithography and a method for manufacturing a semiconductor device using the same. The method for manufacturing a semiconductor device includes forming a photoresist film on a substrate, performing a first exposure process and a development process on the photoresist film to form photoresist patterns, and performing a second exposure process on the photoresist patterns. The photoresist film includes a polymer containing a repeating unit having an azobenzene group or a metal oxide nanocluster having an azobenzene group. The performing of the second exposure process includes controlling an orientation of the azobenzene group within the photoresist patterns according to a polarization direction of incident light.

## Description

### CROSS-REFERENCE TO RELATED APPLICATIONS

This U.S. non-provisional patent application claims priority under 35 U.S.C. § 119 of Korean Patent Application Nos. 10-2024-0016553, filed on February 2, 2024, and 10-2025-0002657, filed on January 8, 2025, the entire contents of which are hereby incorporated by reference.

### BACKGROUND

The present invention relates to a resist composition for photolithography, used for the manufacture of a semiconductor device and a method for manufacturing a semiconductor device using the same.

This research was conducted with the support of Samsung Science & Technology Foundation (Project No. SRFC-MA2301-02).

Photolithography may include an exposure process and a development process. The exposure process may include irradiating a resist film with light of a specific wavelength to induce changes in the chemical structure of the resist film. The development process may include selectively removing an exposed portion or an unexposed portion of the resist film by using a difference in solubility between the exposed portion and the unexposed portion.

Recently, as semiconductor devices are highly integrated and downsized, line widths of patterns in the semiconductor devices become finer. To form fine patterns, a wide range of research is underway to enhance the resolution and sensitivity of resist patterns formed by photolithography and to reduce line edge roughness (LER) of the resist patterns.

### SUMMARY

A technical aspect to be achieved by the present invention is to provide a resist composition enabling photoresist patterns to exhibit enhanced resolution and reduced line edge roughness (LER), and a method for manufacturing a semiconductor device using the same.

Another technical aspect to be achieved by the present invention is to provide a resist composition enabling photoresist patterns to be readily controlled in line width and/or pitch thereof, and a method for manufacturing a semiconductor device using the same.

However, aspects of the present invention are not limited to the aforesaid, but other aspects not described herein will be clearly understood by those skilled in the art from the descriptions below.

A method for manufacturing a semiconductor device according to the present invention may include forming a photoresist film on a substrate, performing a first exposure process and a development process on the photoresist film to form photoresist patterns, and performing a second exposure process on the photoresist patterns. The photoresist film may include a polymer containing a repeating unit having an azobenzene group or a metal oxide nanocluster having an azobenzene group. The performing of the second exposure process may include controlling an orientation of the azobenzene group within the photoresist patterns according to a polarization direction of incident light.

A resist composition for photolithography according to the present invention may include a polymer containing a repeating unit having an azobenzene group or a metal oxide nanocluster having an azobenzene group.

A method for manufacturing a semiconductor device according to the present invention may include forming a photoresist film on a substrate, performing a first exposure process and a development process on the photoresist film to form photoresist patterns, and performing a second exposure process on the photoresist patterns. The photoresist film may include a polymer containing a repeating unit having an azobenzene group or a metal oxide nanocluster having an azobenzene group. The second exposure process may include irradiating the photoresist patterns with incident light having linear polarization.

### BRIEF DESCRIPTION OF THE DRAWINGS

The accompanying drawings are included to provide a further understanding of the inventive concept, and are incorporated in and constitute a part of this specification. The drawings illustrate embodiments of the inventive concept and, together with description, serve to explain principles of the inventive concept. In the drawings:
FIGS. 1, 3, 6, and 11 are plan views showing a method for manufacturing a semiconductor device using a resist composition according to embodiments of the present invention;
FIGS. 2, 4, 7, and 12 are cross-sectional views taken along line I-I' of FIGS. 1, 3, 6, and 11, respectively;
FIG. 5 is an enlarged view showing portion A of FIG. 3;
FIG. 8 is a conceptual view for describing a second exposure process of FIG. 7;
FIGS. 9 and 10 are enlarged views showing portion B of FIG. 6;
FIG. 13 is a graph showing the results of nuclear magnetic resonance spectroscopy (NMR) analysis of a monomer (DR1m) synthesized in Synthesis Example 1;
FIG. 14 is a graph showing the results of NMR analysis of a polymer (pDR1m) synthesized in Synthesis Example 1;
FIGS. 15 and 16 are graphs showing the results of nuclear magnetic resonance spectroscopy (NMR) analysis of a polymer (p(MMA-r-DR1m)) synthesized in Synthesis Example 2;
FIGS. 17 and 18 are graphs showing the results of nuclear magnetic resonance spectroscopy (NMR) analysis of a tin oxide nanocluster (Tin Tos) synthesized in Synthesis Example 3;
FIGS. 19 and 20 are graphs showing the results of nuclear magnetic resonance spectroscopy (NMR) analysis of a tin oxide nanocluster (Tin OH) synthesized in Synthesis Example 3;
FIGS. 21 and 22 are graphs showing the results of nuclear magnetic resonance spectroscopy (NMR) analysis of a tin oxide nanocluster (Azo Tin-oxo) synthesized in Synthesis Example 3;
FIG. 23 is a polarization optical microscope (POM) image for determining an arrangement of azobenzene molecules in resist patterns according to Experimental Example 4;
FIG. 24 is a graph showing the results of numerical analysis of plastic deformation of resist patterns according to Experimental Example 4; and
FIG. 25 is a scanning electron microscope image of resist patterns according to Experimental Example 4.

### DETAILED DESCRIPTION

In order to fully understand configuration and effects of the inventive concept, preferred embodiments of the present invention will be described with reference to the accompanying drawings. However, the present invention may be embodied in different forms and variously modified and changed, and should not be constructed as limited to embodiments set forth herein. Rather, these embodiments are provided so that the present invention will be thorough and complete, and will fully convey the scope of the present invention to those skilled in the art to which the invention pertains. Those skilled in the art will appreciate that the present invention may be carried out in a certain suitable environment.

Terms used herein are not for limiting the present invention but for describing embodiments. As used herein, singular terms are intended to include plural forms as well, unless the context clearly indicates otherwise. It will be further understood that the terms 'comprises' and/or 'comprising' as used herein specify the presence of stated elements, steps, operations, and/or components, but do not preclude the presence or addition of one or more other elements, steps, operations, and/or components.

As used herein, an alkyl group includes a monovalent saturated hydrocarbon group of a linear chain, branched chain, or cyclic chain, unless otherwise indicated.

As used herein, an alkylene group includes a divalent saturated hydrocarbon group of a linear chain, branched chain, or cyclic chain, unless otherwise indicated.

As used herein, halogenated alkyl is an alkyl group in which at least one hydrogen is substituted with halogen, halogenated alkylene is an alkylene group in which at least one hydrogen is substituted with halogen, halogenated aryl is an aryl group in which at least one hydrogen is substituted with halogen, and halogenated alkoxy is an alkoxy group in which at least one hydrogen is substituted with halogen.

As used herein, a halogen group is -F, -Cl, -Br, or -I.

As used herein, "substituted" indicates that at least some of the hydrogen atoms are substituted with functional groups or atoms other than hydrogen atoms. For example, a substituent may be at least one selected from the group consisting of halogen, a hydroxyl group, an alkoxy group, an ether group, a halogenated alkyl group, a halogenated alkoxy group, a halogenated ether group, an alkyl group, an alkenyl group, an aryl group, a hydrocarbon ring group, and a heterocyclic group.

As used herein, a case of not drawing a chemical bond at a position where a chemical bond is required may indicate that a hydrogen atom is bonded at the position, unless otherwise defined.

Hereinafter, embodiments of the present invention are described in detail with reference to attached drawings.

### A resist composition according to embodiments of the present invention will be described.

The resist composition according to embodiments of the present invention may be used for the manufacture of a semiconductor device and may be used in a photolithography process for the manufacture of a semiconductor device. The resist composition may be used, for example, in ultraviolet (UV), deep ultraviolet (DUV), extreme ultraviolet (EUV), or electron beam (e-beam) lithography processes. The extreme ultraviolet may indicate ultraviolet having a wavelength of 10 nm to 124 nm, particularly, a wavelength of 13.0 nm to 13.9 nm, and more particularly, a wavelength of 13.4 nm to 13.6 nm.

The resist composition may include a polymer containing a repeating unit having an azobenzene group or a metal oxide nanocluster having an azobenzene group.

According to some embodiments, the polymer may include a repeating unit represented by Formula 1.

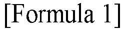

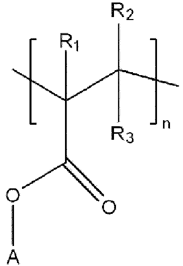

In Formula 1, R1, R2, and R3 are each independently hydrogen or an alkyl group having 1 to 10 carbon atoms, and A is a functional group represented by Formula 2. n is an integer of 2 to 10,000.

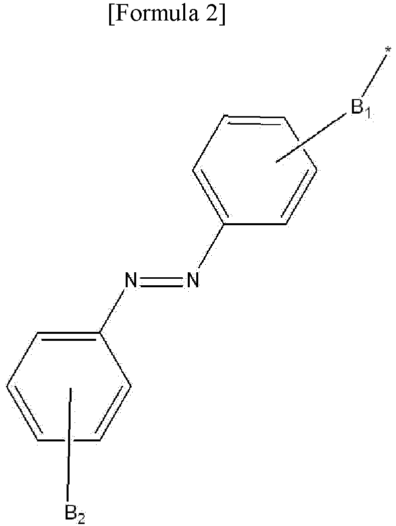

In Formula 2, B1 is a linking group represented by Formula 3, Formula 4, or Formula 5, B2 is hydrogen, a halogen group, an alkyl group having 1 to 10 carbon atoms, - OH, -COOH, or -NO₂, and * is a portion bonded to oxygen in Formula 1.

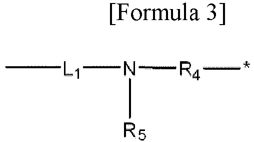

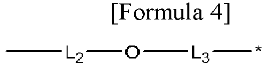

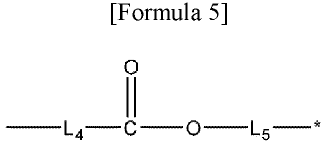

In Formulas 3 to 5, L1, L2, L3, L4, and L5 are each independently a single bond or an alkylene group having 1 to 10 carbon atoms, and * is a portion bonded to oxygen in Formula 1.

In Formula 3, R4 is an alkylene group having 1 to 10 carbon atoms, R5 is hydrogen, an alkyl group having 1 to 10 carbon atoms, -CₓH₂ₓ-CN, -CₓH₂ₓ-OH, or -CₓH₂ₓ-ORa, where x is an integer of 1 to 10, and Ra is an alkyl group having 1 to 10 carbon atoms.

The polymer may include a repeating unit represented by Formula 1-1.

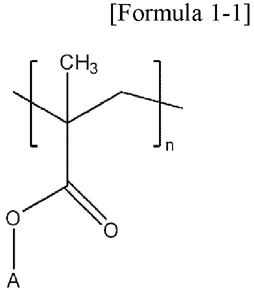

In Formula 1-1, A is a functional group represented by Formula 2-1, and n is an integer from 2 to 10,000.

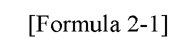

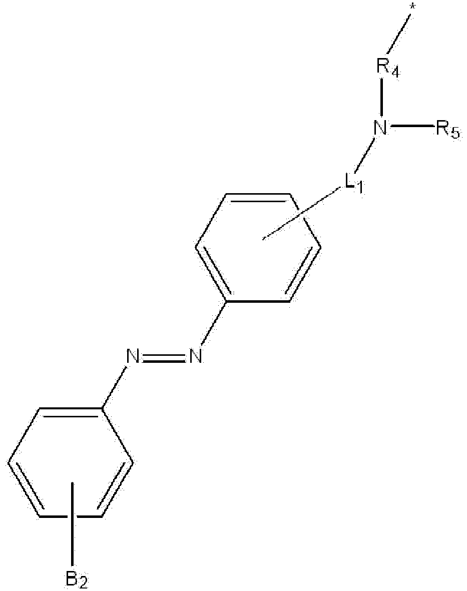

In Formula 2-1, L1 is a single bond or an alkylene group having 1 to 10 carbon atoms, R4 is an alkylene group having 1 to 10 carbon atoms, R5 is hydrogen, an alkyl group having 1 to 10 carbon atoms, -CₓH₂ₓ-CN, -CₓH₂ₓ-OH, or -CₓH₂ₓ-ORa, where x is an integer of 1 to 10, Ra is an alkyl group having 1 to 10 carbon atoms, B2 is hydrogen, a halogen group, an alkyl group having 1 to 10 carbon atoms, -OH, -COOH, or -NO₂, and * is a portion bonded to oxygen in Formula 1-1.

The polymer may include a repeating unit represented by Formula 1-2.

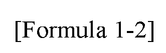

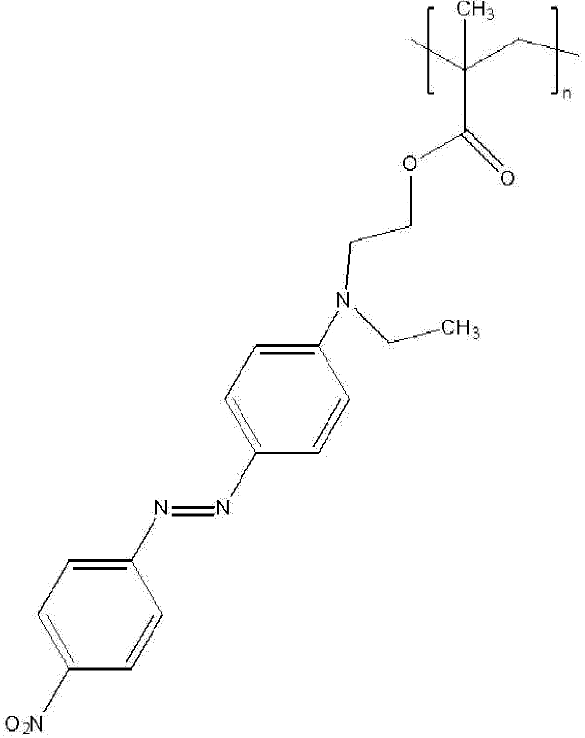

In Formula 1-2, n is an integer of 2 to 10,000.

According to some embodiments, the polymer may include a copolymer represented by Formula 6.

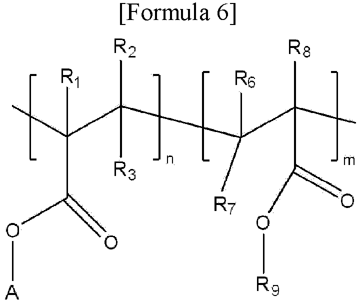

In Formula 6, R1, R2, R3, R6, R7, R8, and R9 are each independently hydrogen or an alkyl group having 1 to 10 carbon atoms, and A is a functional group represented by Formula 2. n and m are an integer of 2 to 10,000.

The polymer may include, for example, a copolymer represented by Formula 6-1.

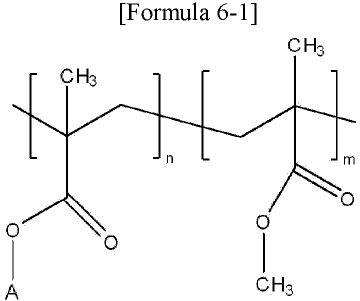

In Formula 6-1, A is a functional group represented by Formula 2-1, and n and m are an integer of 2 to 10,000.

The polymer may include, for example, a copolymer represented by Formula 6-2.

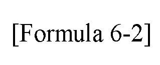

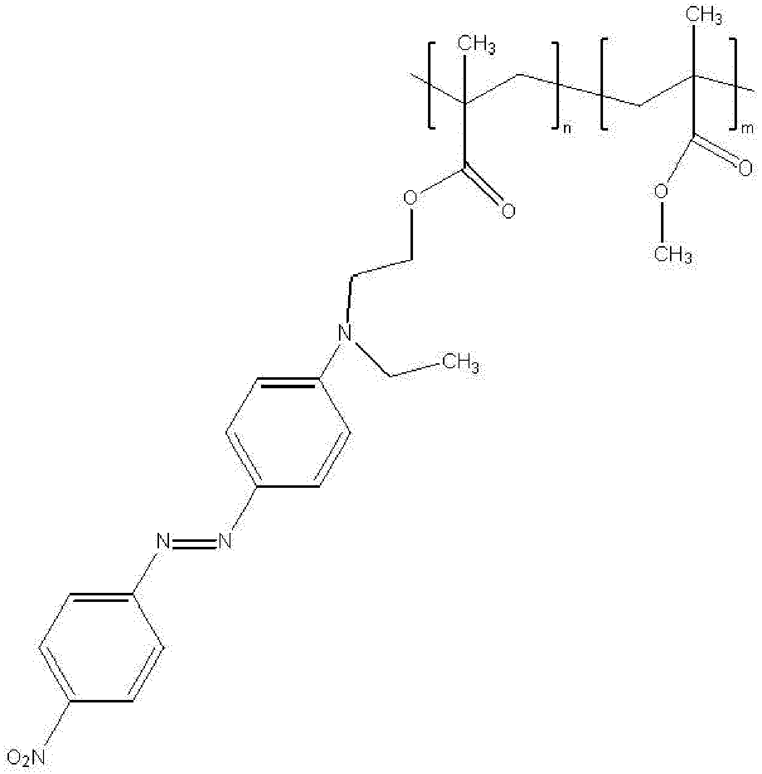

In Formula 6-2, n and m are an integer of 2 to 10,000.

According to some embodiments, the metal oxide nanocluster may include a core structure containing a metal oxide, and an azobenzene group bonded to the core structure. The metal oxide nanocluster may be represented by Formula 7.

[Formula 7] [(R-M)₁₂O₁₄(OH)₆]²⁺[Rx⁻]₂

In Formula 7, M is a metal, at least one selected from the group consisting of tin (Sn), zinc (Zn), lithium (Li), sodium (Na), potassium (K), beryllium (Be), magnesium (Mg), calcium (Ca), barium (Ba), aluminum (Al), silicon (Si), cadmium (Cd), mercury (Hg), chromium (Cr), iron (Fe), cobalt (Co), nickel (Ni), copper (Cu), germanium (Ge), palladium (PD), platinum (Pt), lead (Pb), strontium (Sr), and manganese (Mn).

In Formula 7, R is an alkyl group having 1 to 20 carbon atoms, and Rx⁻ is a counter anion represented by Formula 8.

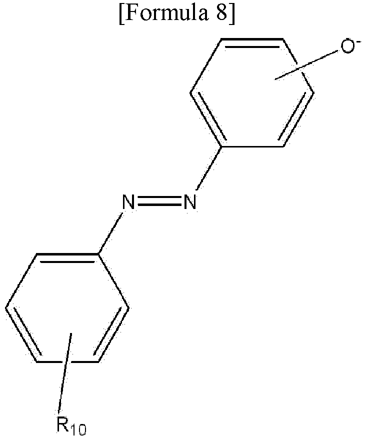

In Formula 8, R10 is -H, -OH, -COOH, an alkyl group having 1 to 10 carbon atoms, or a halogen group.

The metal oxide nanocluster may be, for example, a tin oxide nanocluster represented by Formula 7-1.

[Formula 7-1] [(R-Sn)₁₂O₁₄(OH)₆]²⁺[Rx⁻]₂

In Formula 7-1, R is an alkyl group having 1 to 20 carbon atoms, and Rx⁻ is a counter anion represented by Formula 8-1.

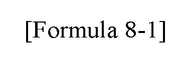

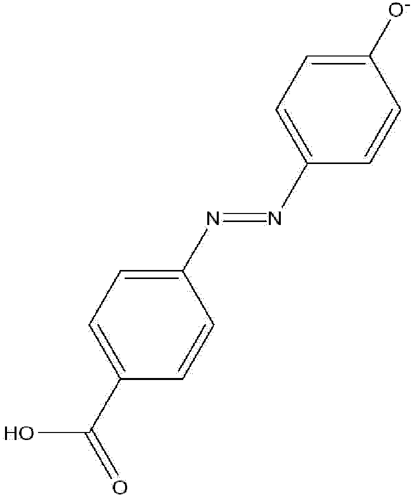

### A method for manufacturing a semiconductor device using a resist composition according to embodiments of the present invention will be described.

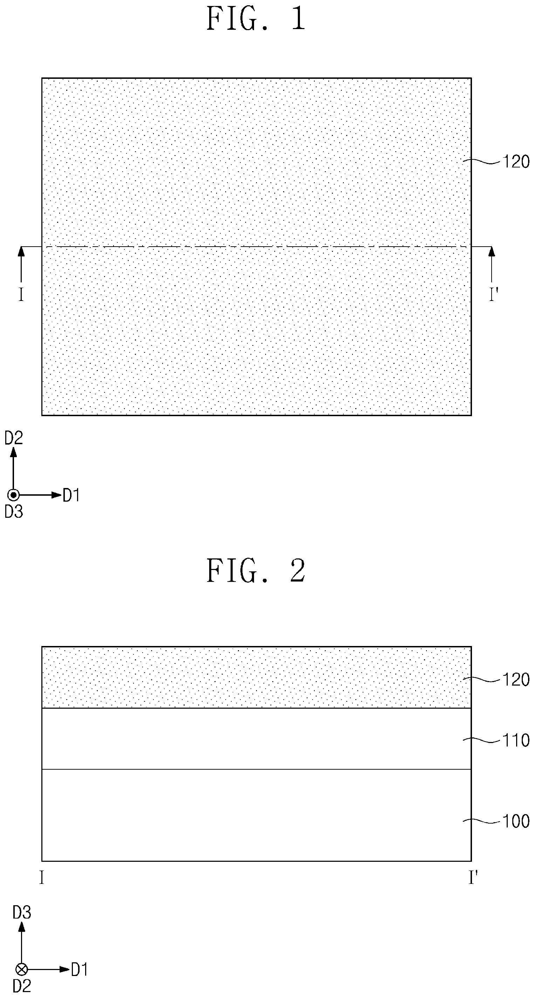

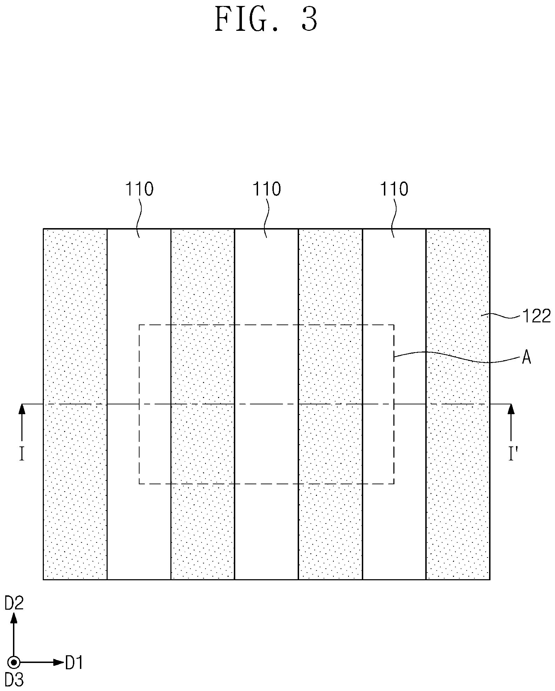

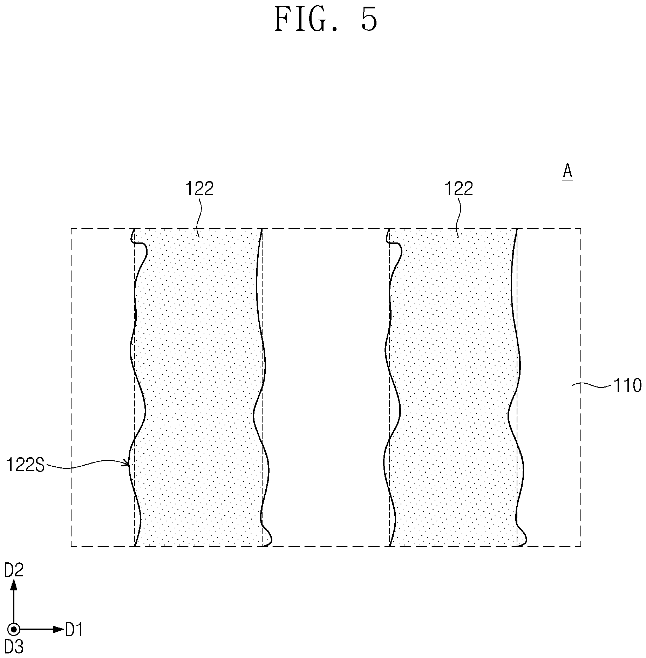

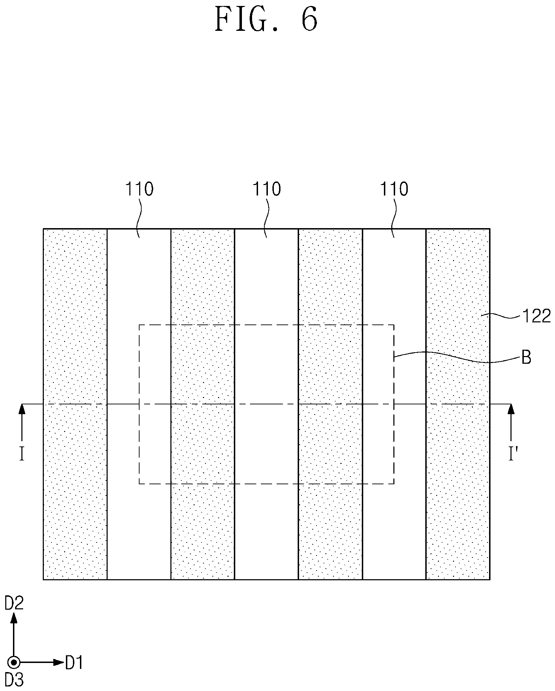

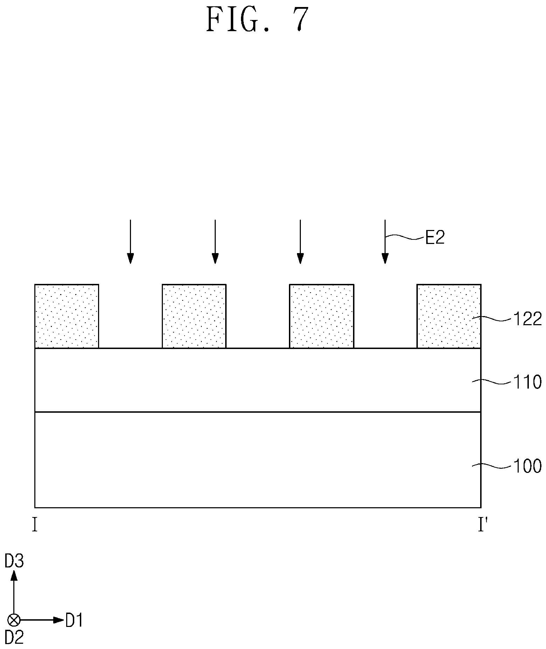

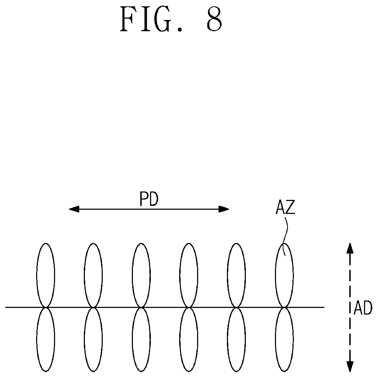

FIGS. 1, 3, 6, and 11 are plan views showing a method for manufacturing a semiconductor device using a resist composition according to embodiments of the present invention, and FIGS. 2, 4, 7, and 12 are cross-sectional views taken along line I-I' of FIGS. 1, 3, 6, and 11, respectively. FIG. 5 is an enlarged view showing portion A of FIG. 3, and FIGS. 9 and 10 are enlarged views showing portion B of FIG. 6. FIG. 8 is a conceptual view for describing a second exposure process of FIG. 7.

Referring to FIGS. 1 and 2, an etching target film 110 may be formed on a substrate 100, and a photoresist film 120 may be formed on the etching target film 110. The substrate 100 may be a semiconductor substrate, and for example, may be a silicon substrate, a germanium substrate, or a silicon/germanium substrate. The etching target film 110 may be formed of any one selected from or a semiconductor material, a conductive material, and an insulating material, a combination thereof. The etching target film 110 may be formed as a single film, or may include a plurality of films stacked on the substrate 100.

The photoresist film 120 may include the resist composition according to embodiments of the present invention. The resist composition may include a polymer containing a repeating unit having an azobenzene group or a metal oxide nanocluster having an azobenzene group. The forming of the photoresist film 120 may include, for example, applying the resist composition onto the etching target film 110 using spin coating, dip coating, blade coating, or spray coating. The forming of the photoresist film 120 may further include performing a heat treatment process (e.g., a soft baking process) on the applied resist composition.

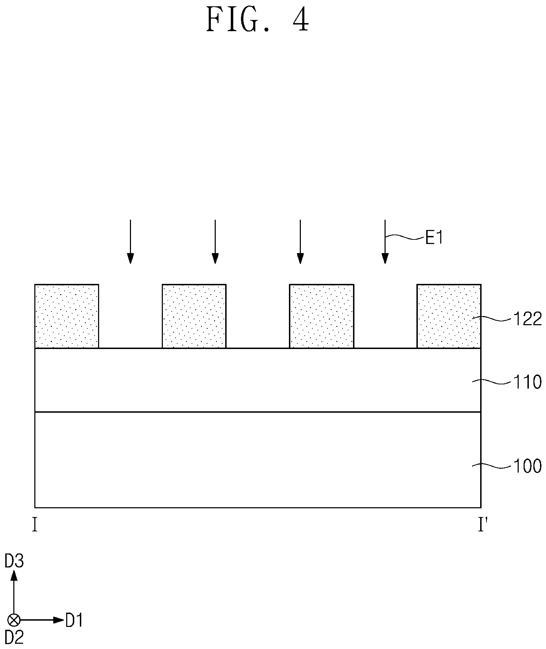

Referring to FIGS. 3 and 4, a first exposure process E1 and a development process may be performed on the photoresist film 120, and accordingly, photoresist patterns 122 may be formed.

The first exposure process E1 may include irradiating the photoresist film 120 with first light. The first light may be ultraviolet rays, deep ultraviolet rays, extreme ultraviolet rays, or electron beams. For example, the first exposure process E1 may include aligning a photomask on the photoresist film 120, and irradiating the photoresist film 120 with the first light (e.g., ultraviolet rays, deep ultraviolet rays, or extreme ultraviolet rays) through the photomask. As another example, the first exposure process E1 may include irradiating and scanning the photoresist film 120 with the first light (e.g., electron beams) using an electron beam lithography device.

The development process may be performed on the exposed photoresist film 120. The performing of the development process may include selectively removing an exposed portion or an unexposed portion of the photoresist film 120 using a developer. The photoresist patterns 122 may be remaining portions of the photoresist film 120 remaining on the etching target film 110 after the development process.

Referring to FIGS. 3 and 5, the photoresist patterns 122, for example, may be spaced apart from each other in a first direction D1 and extended in a second direction D2. The first direction D1 and the second direction D2 may be parallel to an upper surface of the substrate 100 and may cross each other. The photoresist patterns 122 may each have side surfaces 122S opposite to each other in the first direction D1. After the first exposure process E1 and the development process, the side surfaces 122S of the photoresist patterns 122 may have relatively large surface roughness. That is, the photoresist patterns 122 may have relatively large line edge roughness (LER).

Referring to FIGS. 6 and 7, a second exposure process E2 may be performed on the photoresist patterns 122. The second exposure process E2 may include irradiating the photoresist patterns 122 with second light. The second light may be visible light or ultraviolet rays. The second exposure process E2 may include, for example, irradiating the photoresist patterns 122 with the second light using a laser.

Referring to FIG. 8, the second light of the second exposure process E2 may have linear polarization. During the second exposure process E2, the second light may be incident onto the photoresist patterns 122, with a polarization direction PD. A long axis of an azobenzene group AZ in the photoresist patterns 122 may be aligned in a direction perpendicular to the polarization direction PD of the second light. That is, an orientation direction AD in which the long axis of the azobenzene group AZ is aligned may be perpendicular to the polarization direction PD.

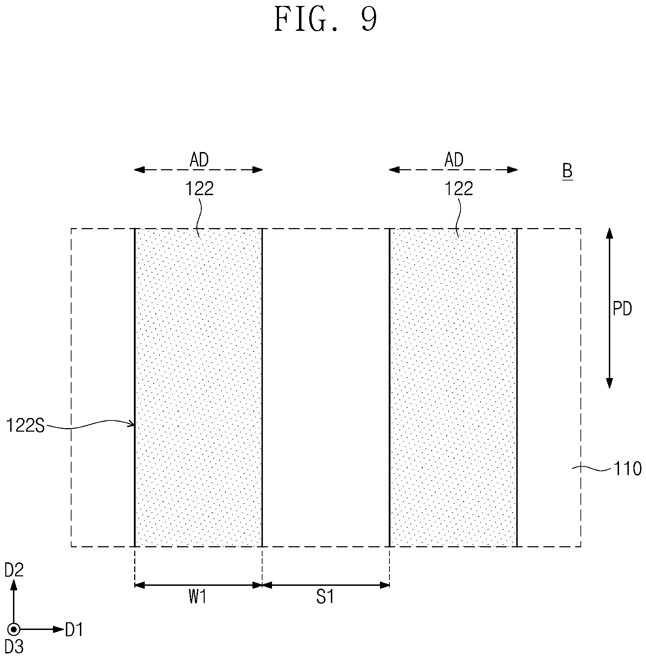

Referring to FIGS. 6 and 9, according to some embodiments, during the second exposure process E2, the second light may be incident such that the polarization direction PD is parallel to a longitudinal direction of the photoresist patterns 122. For example, the polarization direction PD of the second light may be parallel to the second direction D2. The long axis of the azobenzene group AZ in the photoresist patterns 122 may be aligned in a direction perpendicular to the polarization direction PD of the second light, and accordingly, the orientation direction AD in which the long axis of the azobenzene group AZ is aligned may be parallel to the first direction D1. As the long axis of the azobenzene group AZ in the photoresist patterns 122 is aligned parallel to the first direction D1, the surface roughness of the side surfaces 122S of the photoresist patterns 122 may be reduced. That is, the line edge roughness (LER) of the photoresist patterns 122 may be reduced.

The photoresist patterns 122 may each have a first width W1 along the first direction D1, and the photoresist patterns 122 may be spaced apart by a first distance S1 along the first direction D1. As the long axis of the azobenzene group AZ in the photoresist patterns 122 is aligned parallel to the first direction D1, stress along the second direction D2 (i.e., tensile stress along the direction parallel to the polarization direction PD of the second light) may be applied to the photoresist patterns 122. Accordingly, the first width W1 of each of the photoresist patterns 122 may substantially remain the same or be reduced, and the first distance S1 between the photoresist patterns 122 may substantially remain the same or be increased.

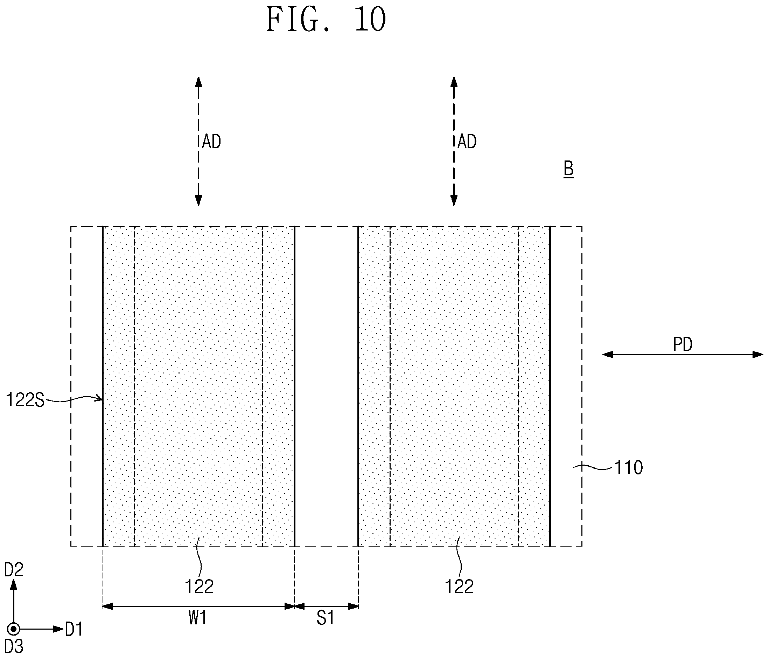

Referring to FIGS. 6 and 10, according to other embodiments, during the second exposure process E2, the second light may be incident such that the polarization direction PD is perpendicular to a longitudinal direction of the photoresist patterns 122. For example, the polarization direction PD of the second light may be parallel to the first direction D1. The long axis of the azobenzene group AZ in the photoresist patterns 122 may be aligned in a direction perpendicular to the polarization direction PD of the second light, and accordingly, the orientation direction AD in which the long axis of the azobenzene group AZ is aligned may be parallel to the second direction D2. As the long axis of the azobenzene group AZ in the photoresist patterns 122 is aligned parallel to the second direction D2, the surface roughness of the side surfaces 122S of the photoresist patterns 122 may be reduced. That is, the line edge roughness (LER) of the photoresist patterns 122 may be reduced. In addition, as the long axis of the azobenzene group AZ in the photoresist patterns 122 is aligned parallel to the second direction D2, stress along the first direction D1 (i.e., tensile stress along the direction parallel to the polarization direction PD of the second light) may be applied to the photoresist patterns 122. Accordingly, the first width W1 of each of the photoresist patterns 122 may increase, and the first distance S 1 between the photoresist patterns 122 may decrease.

According to the concept of the present invention, the orientation direction AD of the azobenzene group AZ in the photoresist patterns 122 may be controlled to be parallel to one direction according to the polarization direction PD of the second light incident by the second exposure process E2. Accordingly, the line edge roughness (LER) of the photoresist patterns 122 may be reduced. In addition, as the orientation direction AD of the azobenzene group AZ in the photoresist patterns 122 is controlled to be parallel to one direction, stress may be applied to the photoresist patterns 122 in a direction parallel to the polarization direction PD of the second light, thereby inducing plastic deformation of the photoresist patterns 122. Consequently, the first width W1 of each of the photoresist patterns 122 and the first distance S1 between the photoresist patterns 122 may be readily controlled.

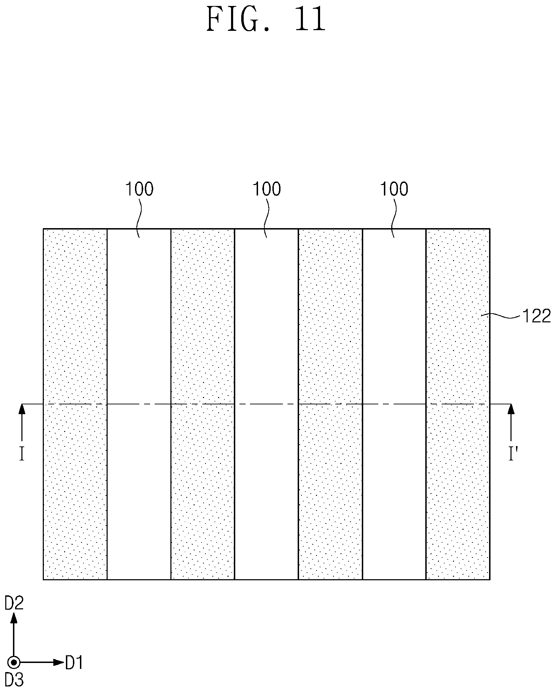

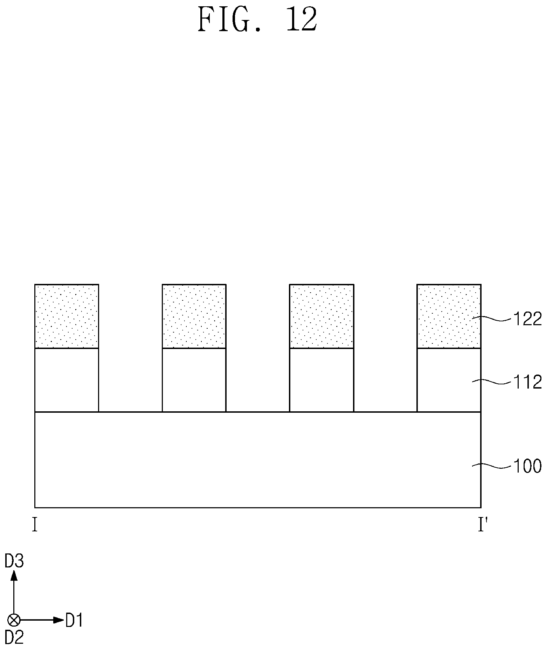

Referring to FIGS. 11 and 12, the etching target film 110 may be etched using the photoresist patterns 122 as an etching mask. The etching of the etching target film 110 may include, for example, performing a wet etching process or a dry etching process. The etching target film 110 may be etched to form target patterns 112. The target patterns 112 may be semiconductor patterns, conductive patterns, or insulation patterns in a semiconductor device. After the forming of the target patterns 112, the photoresist patterns 122 may be removed. The photoresist patterns 122 may be removed, for example, by an ashing process and/or a stripping process.

### [Synthesis Example 1] Synthesis of a polymer (pDR1m) containing a repeating unit represented by Formula 1-2

A monomer (DR1m) represented by Formula 9 may be synthesized according to Reaction Formula 1.

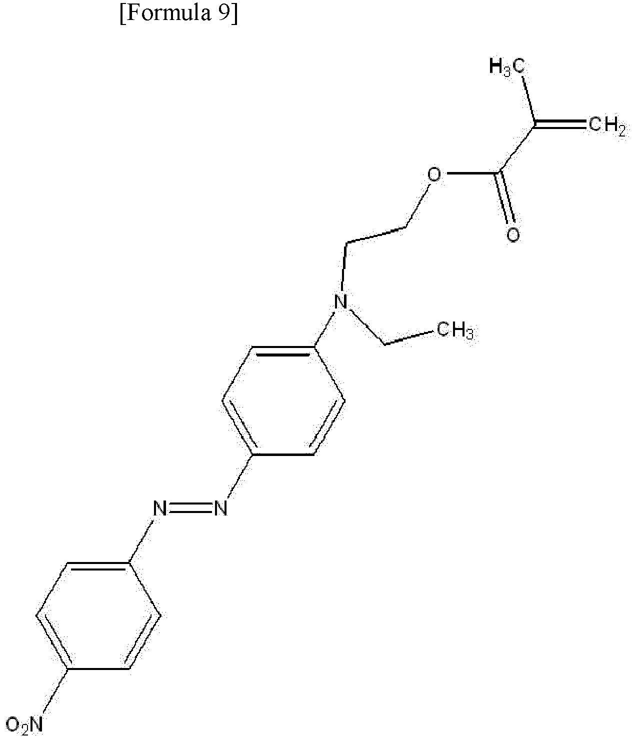

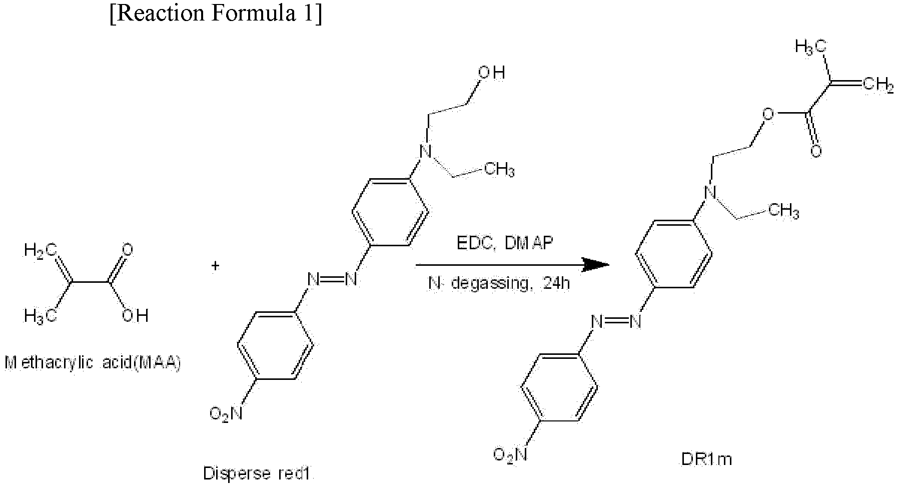

Disperse red1 (purchased from Sigma Aldrich, 10 g) and DMAP (4-dimethylaminopyridine, 0.78 g) are added to methacrylic acid (MAA, 4.05 ml) to form a solution. The solution (DCM 50 ml) is added to a 50 ml round bottom flask and subjected to a reaction through N2 degassing (a process of replacing oxygen inside the flask with N₂ gas) for 30 minutes under stirring in an ice bath. EDC (1-(3-dimethylaminopropyl)-3-ethylcarbodiimide, purchased from TCI, 8.43 ml) is slowly added to the solution and subjected to a further reaction under stirring for 24 hours. A monomer (DR1m) generated from the reaction product is obtained (with respect to 3.18 mmol (1.000 g) of disperse red1, 2.97 mmol (1.136 g) of DR1m is obtained, yield of about 93%).

The monomer (DR1m) represented by Formula 9 may be polymerized according to Reaction Formula 2. Accordingly, a polymer (pDR1m) including a repeating unit represented by Formula 1-2 may be synthesized.

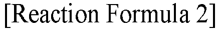

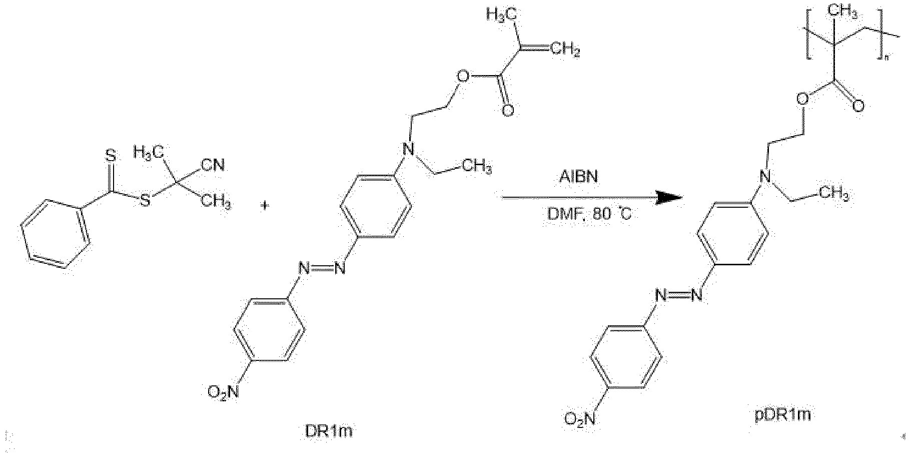

A solution(17 ml) containing 2 g of monomer (DR1m), 0.06 g of RAFT CTA (2-cyano-2-proply benzodithioate), 0.0134 g of AIBN (azobisisobutyronitrile), and dimethylformamide (DMF) is placed in a 50 ml round bottom flask and dissolved by vortexing at room temperature, and the flask was then covered with a rubber septa and sealed with parafilm to perform N2 degassing for about 20 minutes. The reaction mixture is then subjected to a reaction stirred and reacted in an 80 °C oil bath under stirring for 24 hours. The reactant is precipitated using hexane and THF (tetrahydrofuran) to obtained pDR1m (weight average molecular weight (Mw): 3.979*10³ g/mol, polydispersity: 1.263) in the form of a solid powder (with respect to 2 g (5.23 mmol) of DR1m, 1.369 g (3.44 mmol) of pDR1m is obtained, yield of about 66%).

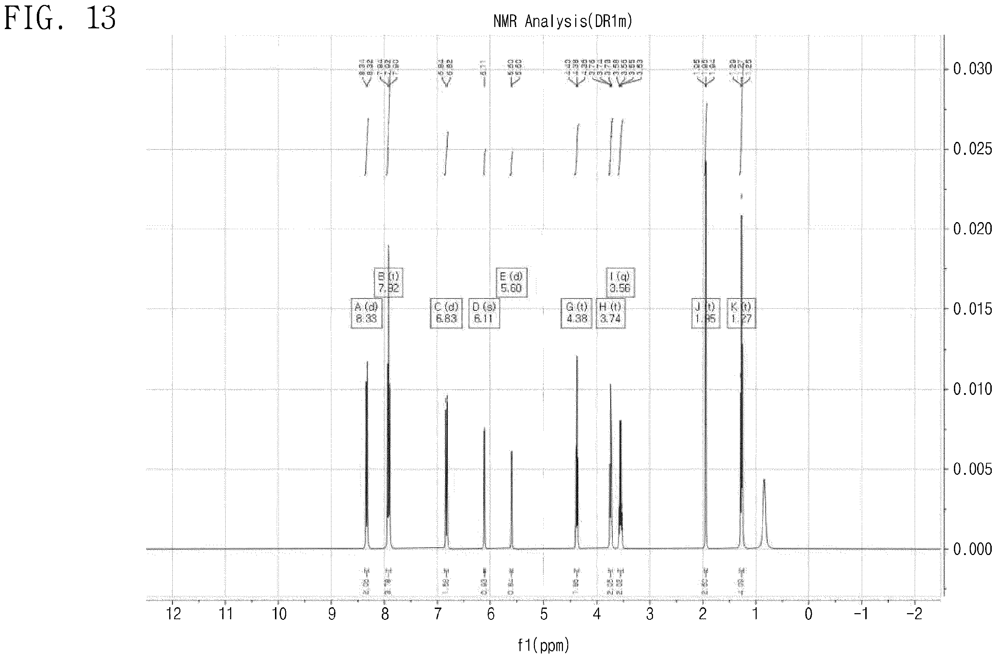

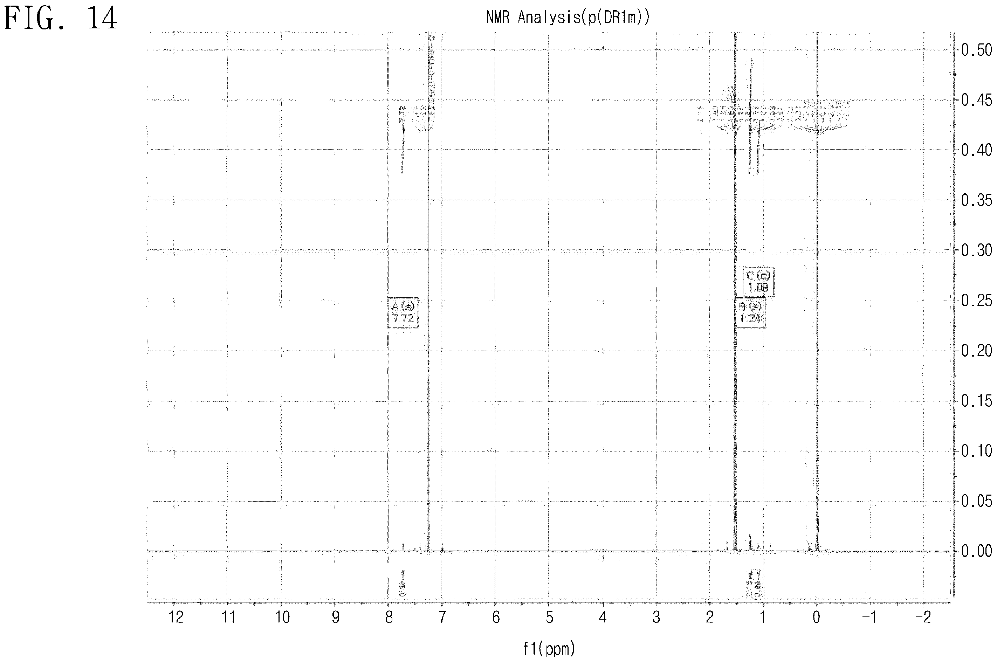

FIG. 13 is a graph showing the results of nuclear magnetic resonance spectroscopy (NMR) analysis of a monomer (DR1m) synthesized in Synthesis Example 1, and FIG. 14 is a graph showing the results of NMR analysis of a polymer (pDR1m) synthesized in Synthesis Example 1.

Referring to FIGS. 13 and 14, it is determined that a monomer (DR1m) represented by Formula 9 and a polymer (pDR1m) including a repeating unit represented by Formula 1-2 are formed according to Synthesis Example 1.

### [Synthesis Example 2] Synthesis of a polymer (p(MMA-r-DR1m)) containing a copolymer represented by Formula 6-2

The monomer (DR1m) represented by Formula 9 may be polymerized according to Reaction Formula 3. Accordingly, a polymer (p(MMA-r-DR1m)) including a copolymer represented by Formula 6-2 may be synthesized.

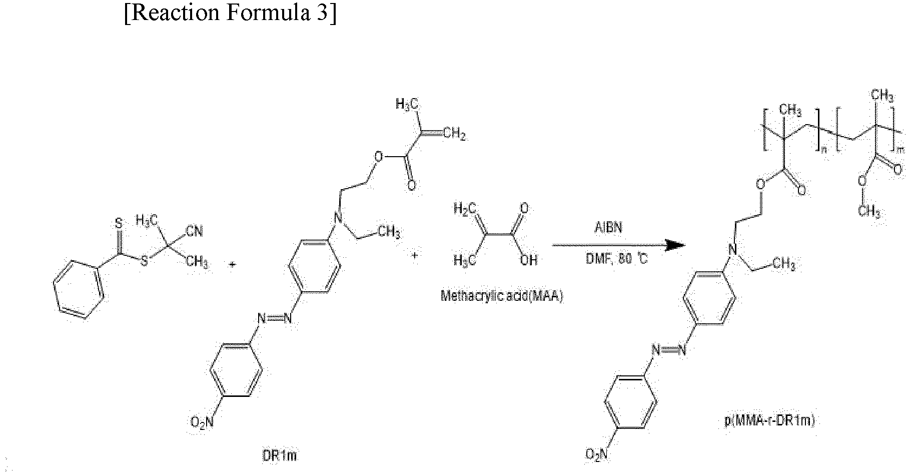

A solution(7.53 ml) containing 0.02 g of RAFT CTA (2-cyano-2-proply benzodithioate), 0.753 g of DR1m, 3.766 g of MAA (methacrylic acid), 0.003 g of AIBN (azobisisobutyronitrile), and dimethylformamide (DMF) is placed in a 50 ml round bottom flask and dissolved by vortexing at room temperature, and the flask was then covered with a rubber septa and sealed with parafilm to perform N2 degassing for about 20 minutes. The reaction mixture is then subjected to a reaction stirred and reacted in an 80 °C oil bath under stirring for 24 hours. A polymer (p(MMA-r-DR1m)) generated from the reactant is obtained (with respect to 0.753 g (2 mmol) of DR1m and 3.766 g (37.7 mmol) of MAA, 2.219 g (8.69 mmol) of polymer is obtained).

Polymer (p(MMA-r-DR1m)) A: weight average molecular weight (Mw): 1.1425*10⁴ g/mol, polydispersity: 3.215.

Polymer (p(MMA-r-DR1m)) B: weight average molecular weight (Mw): 2.557*10⁴ g/mol, polydispersity: 1.609.

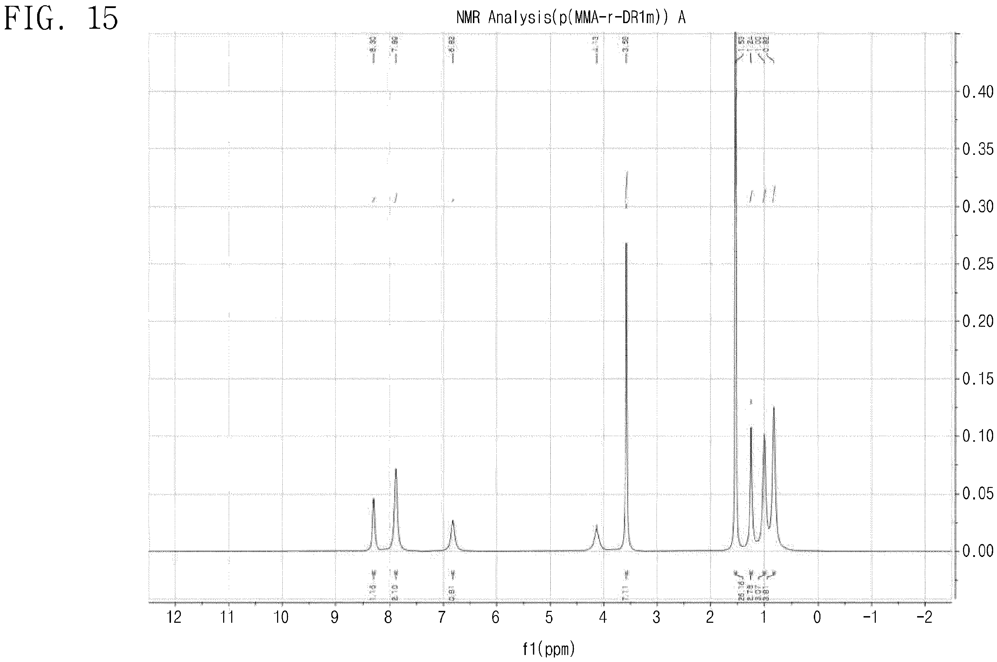

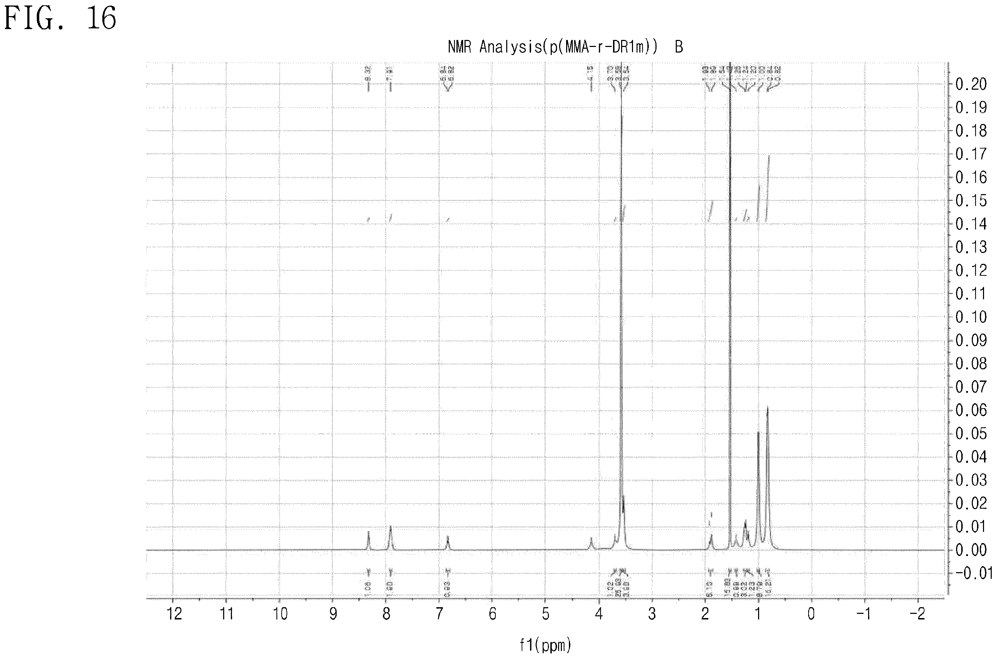

FIGS. 15 and 16 are graphs showing the results of nuclear magnetic resonance spectroscopy (NMR) analysis of a polymer (p(MMA-r-DR1m)) synthesized in Synthesis Example 2.

Referring to FIGS. 15 and 16, it is determined that a polymer (p(MMA-r-DR1m)) including a copolymer represented by Formula 6-2 is formed according to Synthesis Example 2. FIG. 15 shows the results of analysis of polymer (p(MMA-r-DR1m)) A (Mw: 1.1425*10⁴ g/mol), and FIG. 16 shows the results of analysis of polymer (p(MMA-r-DR1m)) B (Mw: 2.557*10⁴ g/mol).

### [Synthesis Example 3] Synthesis of a tin oxide nanocluster represented by Formula 7-1

According to Reaction Formula 4, a tin oxide nanocluster (Tin OH) having a counter anion (-OH) may be synthesized, and according to Reaction Formula 5, the counter anion (-OH) of the tin oxide nanocluster (Tin OH) may be substituted with a counter anion represented by Formula 8-1.

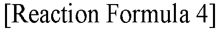

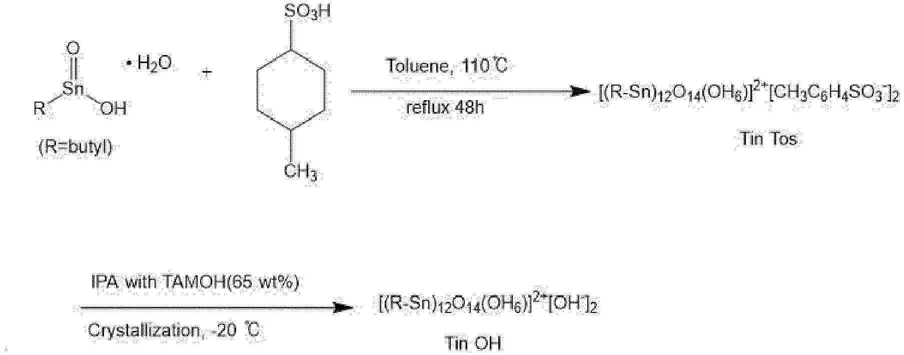

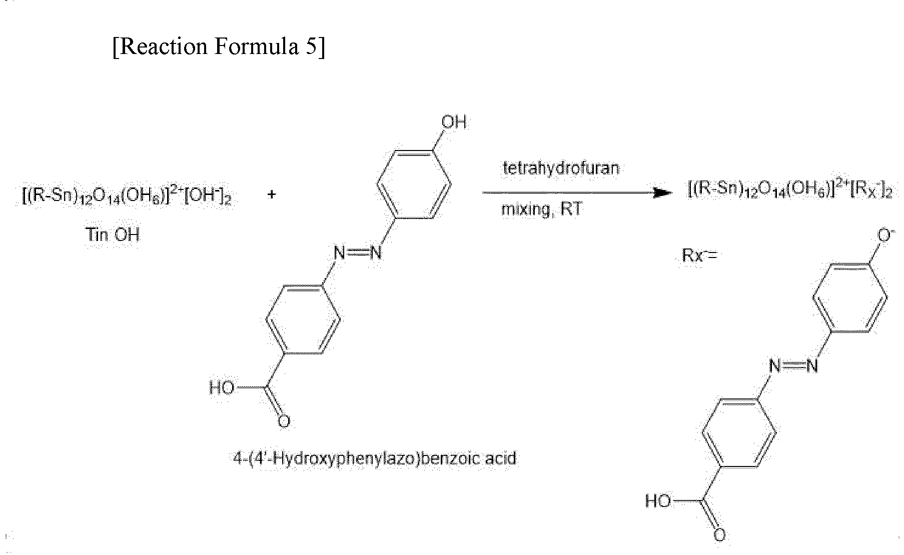

20 g of BuSnO(OH), 5.77 g of p-toluene sulfonic acid, and 500 ml of toluene are added to a 1000 ml round bottom flask and connected to a heating mantle set to 110 °C with dean-stark and condenser glass and subjected to a reaction for 48 hours. The reactant is filtered through glass frit no. 4, and then a solvent is removed using a rotary evaporator, and 1,4-dioxane and 0.5 wt% of water are added and left at room temperature to obtain Tin Tos ([(R-Sn)₁₂O₁₄(OH₆)]²⁺[CH₃C₆H₄SO₃⁻]₂) (about 17 g (7.98 mmol) of Tin Tos, yield of about 53%).

Tin Tos is filtered through glass frit no. 2, and then the remaining solvent in an oven is removed. Thereafter, solid Tin Tos is added to a solution (65 wt%) in which TAMOH (tetramethylammonium hydroxide) is added to IPA, stirred vigorously for about 30 minutes, and left at a temperature of -20 °C for 24 hours to obtain Tin OH ([(Bu-Sn)₁₂O₁₄(OH)₆]²⁺[OH⁻]₂) (with respect to 8 g (2.88 mmol) of Tin Tos, 0.08 g (1.95 mmol) of Tin OH is obtained, yield of about 68%).

A solution in which 0.0382 g of Tin OH is dissolved in 0.382 ml of THF and a solution in which 0.008 g of 4-(4'-hydroxyphenylazo)benzoic acid is dissolved in 0.081 ml of THF are added to a 50 ml round bottom flask and stirred for 10 minutes. Thereafter, a solvent is removed using a rotary evaporator to obtain Azo Tin-oxo([(Bu-Sn)₁₂O₁₄(OH)₆]²⁺[C₁₃H₉N₂O₃⁻]₂) as a solid (with respect to 0.0382 g (0.0932 mmol) of Tin OH, 0.0212 g (0.00751 mmol) of Azo Tin-oxo is obtained, yield of about 46%).

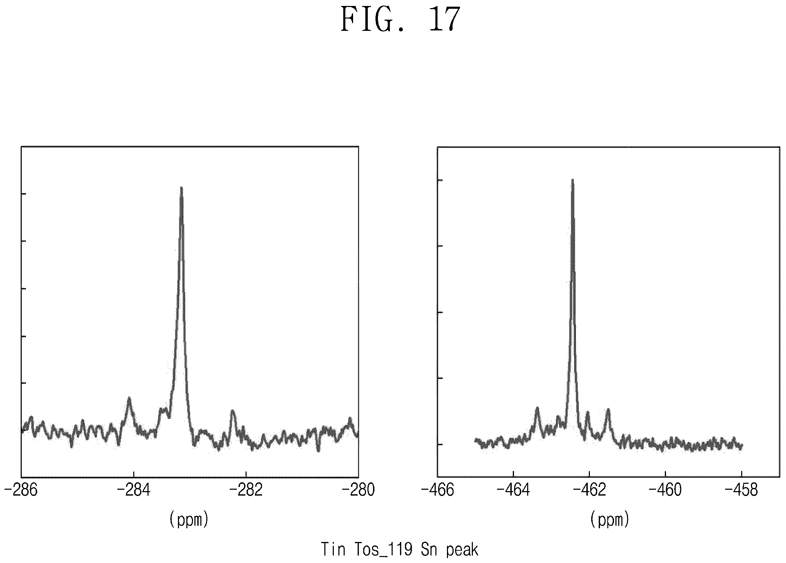

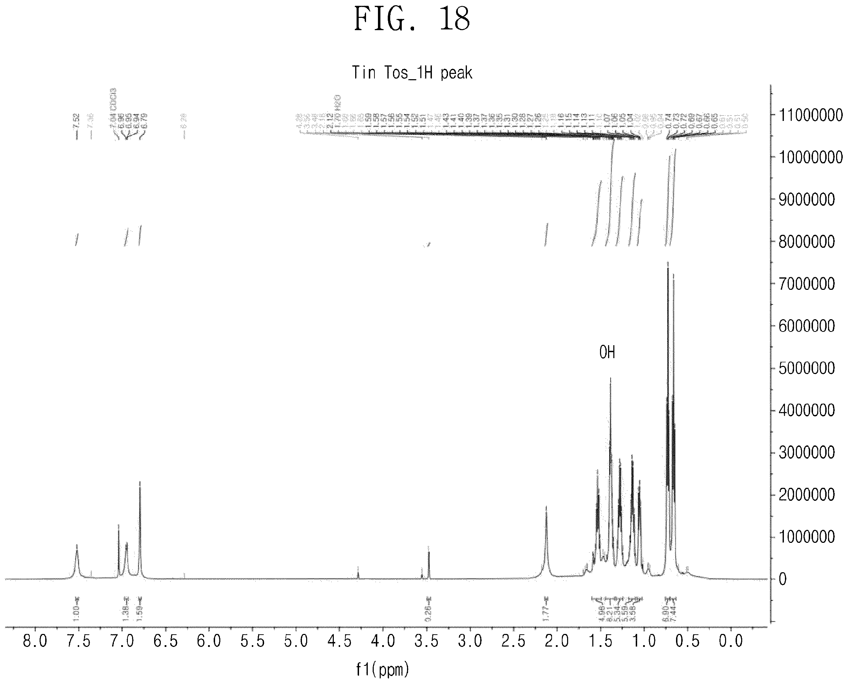

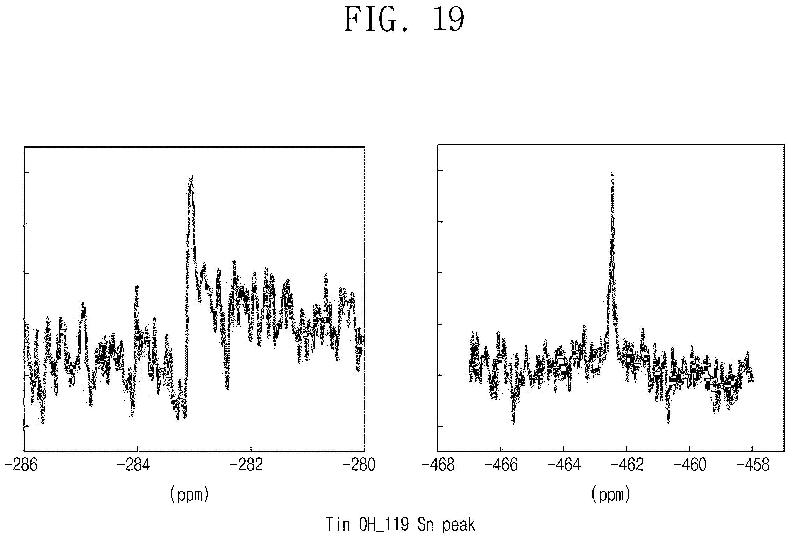

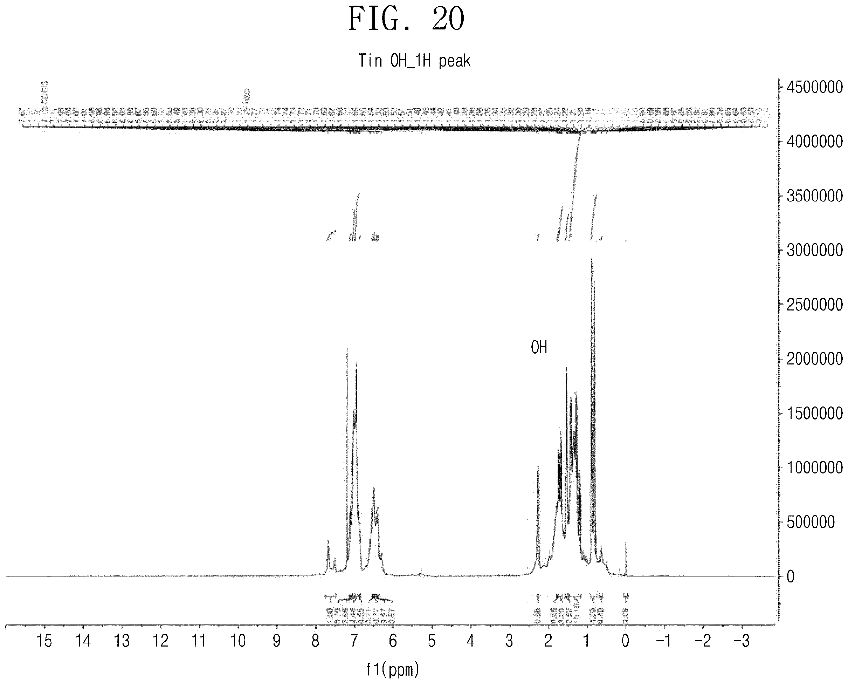

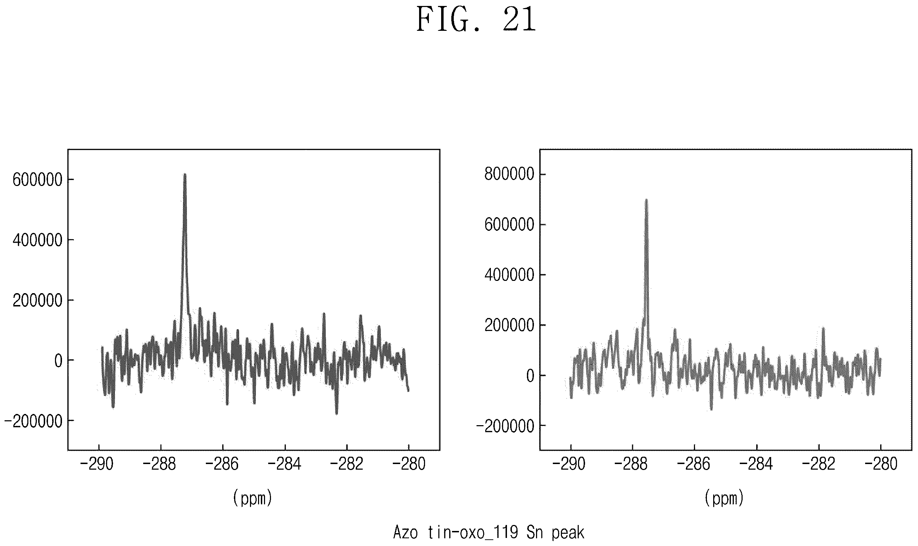

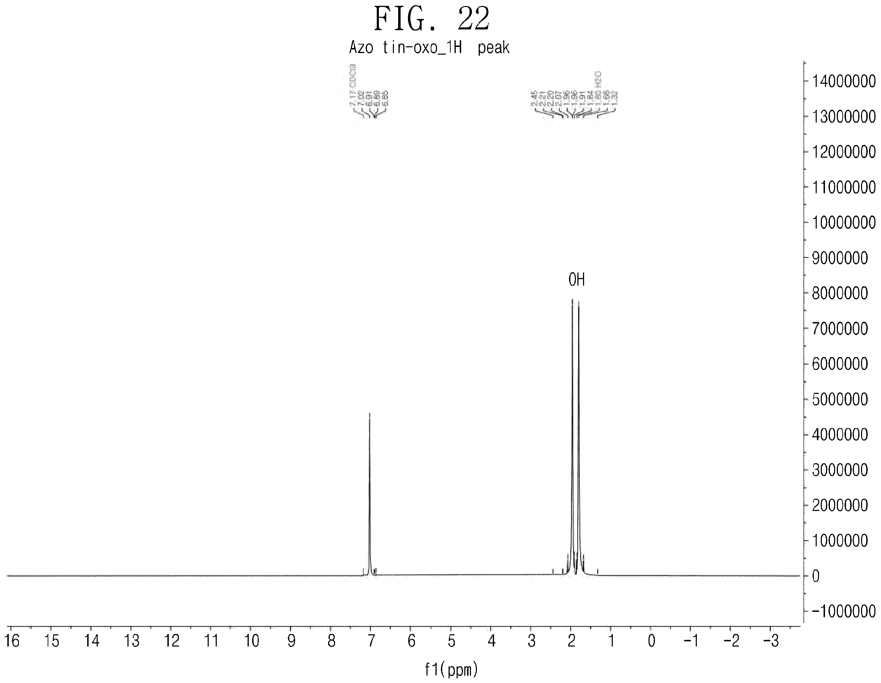

FIGS. 17 and 18 are graphs showing the results of nuclear magnetic resonance spectroscopy (NMR) analysis of a tin oxide nanocluster (Tin Tos) synthesized in Synthesis Example 3, and FIGS. 19 and 20 are graphs showing the results of nuclear magnetic resonance (NMR) analysis of a tin oxide nanocluster (Tin OH) synthesized in Synthesis Example 3. FIGS. 21 and 22 are graphs showing the results of nuclear magnetic resonance (NMR) analysis of a tin oxide nanocluster (Azo Tin-oxo) synthesized in Synthesis Example 3.

Referring to FIGS. 17 and 18, it is determined that a tin oxide nanocluster (Tin Tos) is formed according to Synthesis Example 3.

Referring to FIGS. 19 and 20, it is determined that a tin oxide nanocluster (Tin OH) is formed according to Synthesis Example 3.

Referring to FIGS. 21 and 22, it is determined that a tin oxide nanocluster (Azo Tin-oxo) having an azobenzene group is formed according to Synthesis Example 3.

### [Experimental Example 1] Electron beam lithography evaluation of polymer (pDR1m) - Resist pattern formation

The polymer (pDR1m) synthesized in Synthesis Example 1 is dissolved in 1,1,2-trichloroethane to prepare a 2 wt% solution. The solution is spin coated on a silicon substrate at 4000 rpm for 60 seconds. The coated substrate is heated at 120 °C for 1 minute to form a resist thin film. An exposure process and a development process are performed on the resist thin film under the following conditions to form resist patterns having a half pitch (hp) of 2 µm. During the exposure process, the dose is changed to 100, 300, 500, 700, 900, and 1100 µC/cm². During the development process, a first development uses a mixed solution (a ratio of the mixed solution is in wt%) as a developer, and a second development (rinse) uses a single solution as a developer. In Table 1 below, in samples 5 and 6, the first development time is changed to 1 min, 2 min, and 4 min.

**[Table 1]**

| Item | Resist composition | Resist pattern | Exposure (Dose, µC/cm²) | Developer | Develop time |
|---|---|---|---|---|---|
| 1 | pDRlm | 2 µm hp line pattern | 100/300/500/700/900/1100 | 1st: MIBK/IPA 1:3 | 1st: 30 s |
| | | | | 2nd: IPA | 2nd: 15 s |
| 2 | pDRlm | 2 µm hp line pattern | 100/300/500/700/900/1100 | 1st: DMSO/IPA 1:2 | 1st: 30 s |
| | | | | 2nd: IPA | 2nd: 15 s |
| 3 | pDRlm | 2 µm hp line pattern | 100/300/500/700/900/1100 | 1st: DMSO/DI water 1:1 | 1st: 30 s |
| | | | | 2nd: DI water | 2nd: 15 s |
| 4 | pDRlm | 2 µm hp | 100/300/500/700/900/1100 | 1st: DMSO/DI water 1:2 | 1st: 30 s |
| | | line pattern | | 2nd: DI water | 2nd: 15 s |
| 5 | pDRlm | 2 µm hp | 100/300/500/700/900/1100 | 1st: DMSO/IPA 1:2 | 1st: 1 min, 2 min, 4 min 2nd: 30 s |
| | | line pattern | | 2nd: IPA | |
| 6 | pDRlm | 2 µm hp line pattern | 100/300/500/700/900/1100 | 1st: DMSO/IPA 1:1 | 1st: 1 min, 2 min, 4 min 2nd: 30 s |
| | | | | 2nd: IPA | |

| | | | | | |
|---|---|---|---|---|---|
| (MIBK: methyl isobutyl ketone, IPA: isopropyl alcohol, DMSO: dimethyl sulfoxide) | | | | | |

### [Experimental Example 2] Electron beam lithography evaluation of polymer (p(MMA-r-DR1m)) - Resist pattern formation

The polymer (p(MMA-r-DR1m)) synthesized in Synthesis Example 2 is dissolved in trichloroethylene to prepare a 2 wt% solution, and 0.01 wt% BHT is added to the solution to form a composition. The composition is spin coated on a silicon substrate at 500 rpm for 10 seconds, and then spin coated again at 4000 rpm for 60 seconds. The coated substrate is heated at 120 °C for 1 minute to form a resist thin film (thickness of about 40 to 50 nm). An exposure process and a development process are performed on the resist thin film under the following conditions to form resist patterns having a half pitch of 2 µm (hp) and resist patterns having a half pitch of 250 nm (hp). During the exposure process, the dose is changed to 90, 270, 450, 630, and 810 µC/cm². During the development process, the mixed solution (a ratio of the mixed solution is in wt%) is used as a developer, and the development time is changed to 30 s to 2 min.

**[Table 2]**

| Item | Resist composition | Resist pattern | Exposure (Dose, µC/cm²) | Developer | Develop time |
|---|---|---|---|---|---|
| 1 | p(MMA-r- DR1m) + BHT 0.01 wt% | 2 µm hp line pattern | 90, 270, 450, 630, 810 | Chloroform/IPA 1:3 | 30 s to 2 min |
| 2 | p(MMA-r- DR1m) + BHT 0.01 wt% | 250 nm hp line pattern | 90, 270, 450, 630, 810 | Chloroform/IPA 1:3 | 30 s to 2 min |

| | | | | | |
|---|---|---|---|---|---|
| (BHT: Butylated hydroxytoluene) | | | | | |

### [Experimental Example 3] Electron beam lithography evaluation of tin oxide ([(Bu-Sn)₁₂O₁₄(OH)₆]²⁺[C₁₃H₉N₂O₃⁻]₂) - Resist pattern formation

The tin oxide ([(Bu-Sn)₁₂O₁₄(OH)₆]²⁺[C₁₃H₉N₂O₃⁻]₂) synthesized in Synthesis Example 3 is dissolved in a mixed solvent of toluene and ethanol (volume ratio of toluene and ethanol = 2:1) to prepare a 2 wt% solution. The solution is spin coated on a silicon substrate pretreated with HMDS (hexamethyldisilazane) at 500 rpm for 10 seconds, and then spin coated again at 2000 rpm for 30 seconds. The coated substrate is heated at 90 °C for 1 minute to form a resist film. An exposure process is performed on the resist film under the following conditions, and a post-exposure heating process (PEB) is performed at 150 °C for 2 minutes and an additional heating process (hard baking) is performed at 150 °C for 1 minute. Thereafter, a development process is performed on the exposed resist thin film under the following conditions to form resist patterns having a half pitch (hp) of 250 nm. During the exposure process, the dose is changed to 50, 100, and 1000 µC/cm². During the development process, a mixed solution (a ratio of the mixed solution is in wt%) is used as a developer.

**[Table 3]**

| Item | Resist composition | Resist pattern | Exposure (Dose, µC/cm²) | Developer | Develop time |
|---|---|---|---|---|---|
| 1 | Azo-tin-oxo cluster | 250 nm hp line pattern | 50,100,1000 | IPA/DI 2:1 | 30 s |

### [Experimental Example 4] Evaluation of plastic deformation of resist patterns

The resist patterns formed in Experimental Examples 1 to 3 are irradiated with a laser having a wavelength of 532 nm at 10 to 50 mJ/cm². The resist patterns are irradiated with incident light from the laser in a polarization direction perpendicular to a longitudinal direction of the resist patterns. After the laser irradiation, an arrangement of azobenzene molecules in the resist patterns is determined using a polarization optical microscope (POM), and changes in shape of the resist patterns are determined using a scanning electron microscope.

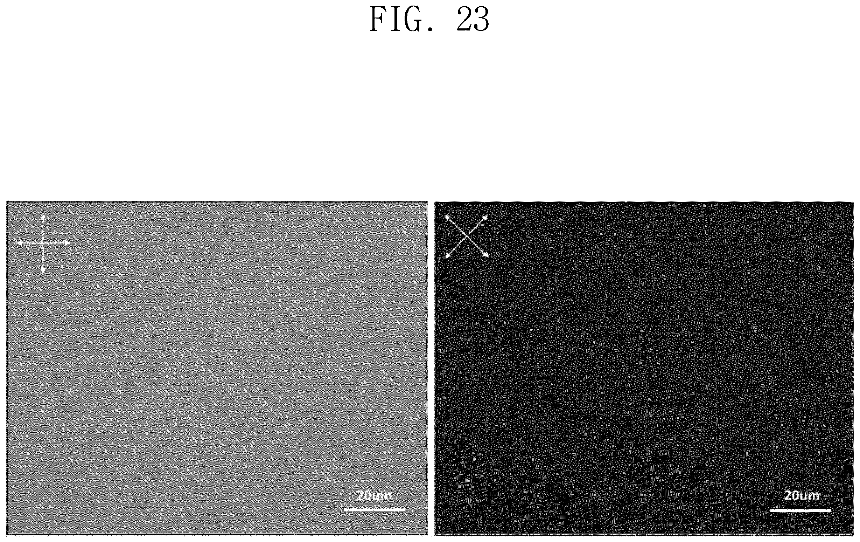

FIG. 23 is a polarization optical microscope (POM) image for determining an arrangement of azobenzene molecules in resist patterns according to Experimental Example 4.

Referring to FIG. 23, it is determined that the azobenzene molecules within the resist patterns are oriented in a certain direction (i.e., a direction perpendicular to the polarization direction of incident light by the laser).

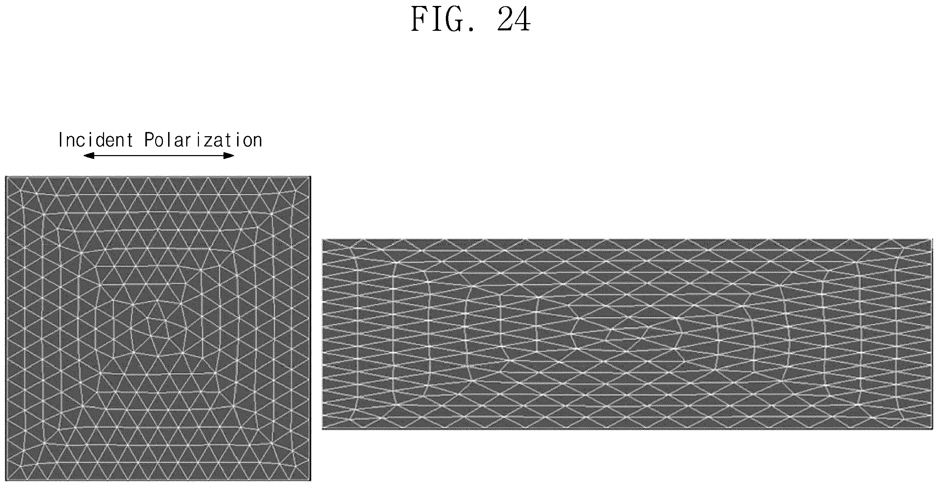

FIG. 24 is a graph showing the results of numerical analysis of plastic deformation of resist patterns according to Experimental Example 4.

Referring to FIG. 24, it is determined that stress may be applied to the resist patterns in a direction parallel to the polarization direction as a long axis of the azobenzene molecules in the resist patterns is oriented in a direction perpendicular to the polarization direction of the incident light. Accordingly, it is determined that the shape of the resist patterns may be changed depending on the polarization direction of the incident light.

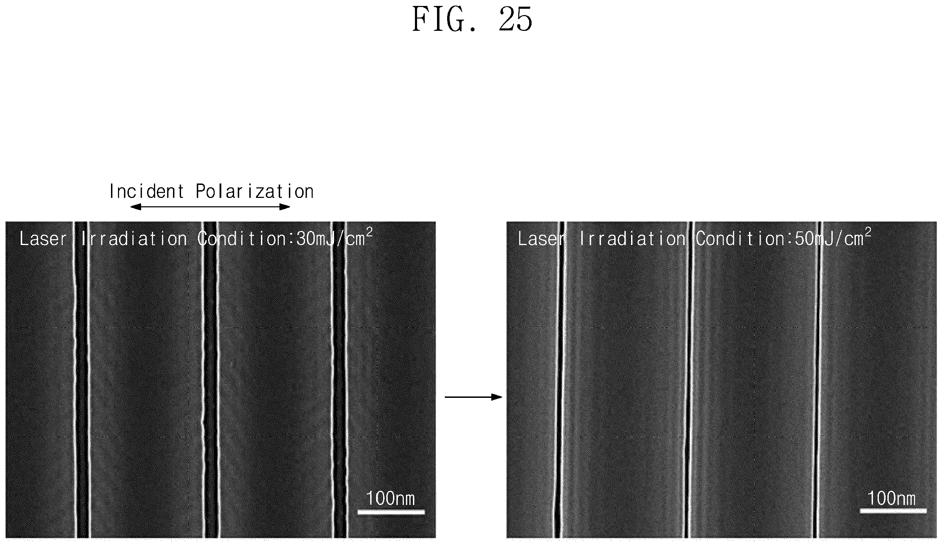

FIG. 25 is a scanning electron microscope image of resist patterns according to Experimental Example 4.

Referring to FIG. 25, when the resist patterns were irradiated with a laser having a wavelength of 532 nm at 30 mJ/cm² according to Experimental Example 4, line edge roughness (LER) was found to be 5.4 nm to 6.1 nm. When the resist patterns were irradiated with a laser having a wavelength of 532 nm at 50 mJ/cm² according to Experimental Example 4, line edge roughness (LER) was found to be 1.8 nm to 2.2 nm. It is determined that the line edge roughness (LER) decreases as the irradiation amount of the laser increases. In addition, it is determined that when the polarization direction of the incident light by the laser is perpendicular to the longitudinal direction of the resist patterns, stress may be applied to the resist patterns in a direction parallel to the polarization direction, and consequently, plastic deformation of the resist patterns take place along the direction parallel to the polarization direction. It is determined that the distance between the resist patterns decreases as the irradiation amount of the laser increases. When the resist patterns were irradiated with a laser having a wavelength of 532 nm at 50 mJ/cm², the distance between the resist patterns were found to be 8.8 nm to 9.4 nm.

According to an idea of the present invention, an orientation of an azobenzene group in photoresist patterns may be controlled according to a polarization direction of incident light incident by a second exposure process. By controlling an orientation direction of the azobenzene group to be parallel to one direction, the line edge roughness (LER) of the photoresist patterns may be reduced, resulting in enhanced resolution of the photoresist patterns. In addition, controlling the orientation direction of the azobenzene group to be parallel to one direction may induce plastic deformation of the photoresist patterns. Accordingly, the line width and/or pitch of the photoresist patterns may be readily controlled.

Consequently, a resist composition capable of enhancing the resolution of photoresist patterns, reducing the line edge roughness (LER) of photoresist patterns, and readily controlling the line width and/or pitch of photoresist patterns, and a method for manufacturing a semiconductor device using the same may be provided.

The above description on embodiments of the present invention provides examples for describing the invention. Thus, the present invention is not limited to the above-described embodiments, and it would be clarified that various modifications and changes, for example, combinations of the above embodiments, could be made by those skilled in the art within the technical spirit of the invention.

Embodiments are set out in the following clauses:
Clause 1. A method for manufacturing a semiconductor device, the method comprising:
   forming a photoresist film on a substrate;
   performing a first exposure process and a development process on the photoresist film to form photoresist patterns; and
   performing a second exposure process on the photoresist patterns,
   wherein the photoresist film includes a polymer containing a repeating unit having an azobenzene group or a metal oxide nanocluster having an azobenzene group, and
   the second exposure process includes irradiating the photoresist patterns with incident light having linear polarization.
Clause 2. The method of clause 1, wherein a polarization direction of the incident light of the second exposure process is parallel to an upper surface of the substrate.
Clause 3. The method of clause 2, wherein during the second exposure process, a long axis of the azobenzene group in the photoresist patterns is aligned in a direction perpendicular to the polarization direction of the incident light.
Clause 4. The method of clause 2 or clause 3, wherein during the second exposure process, plastic deformation of the photoresist patterns is induced along a direction parallel to the polarization direction of the incident light.
Clause 5. The method of any one of clauses 1 to 4, wherein the incident light of the second exposure process is visible light or ultraviolet rays.
Clause 6. The method of any one of clauses 1 to 5, wherein the second exposure process comprises irradiating the photoresist patterns with the incident light using a laser.

## Claims

1. A method for manufacturing a semiconductor device, the method comprising:
forming a photoresist film on a substrate;
performing a first exposure process and a development process on the photoresist film to form photoresist patterns; and
performing a second exposure process on the photoresist patterns,
wherein the photoresist film includes a polymer containing a repeating unit having an azobenzene group or a metal oxide nanocluster having an azobenzene group, and
the performing of the second exposure process includes controlling an orientation of the azobenzene group within the photoresist patterns according to a polarization direction of incident light.

2. The method of claim 1, wherein during the second exposure process, a long axis of the azobenzene group in the photoresist patterns is aligned in a direction perpendicular to the polarization direction of the incident light.

3. The method of claim 1 or claim 2, wherein during the second exposure process, plastic deformation of the photoresist patterns is induced along a direction parallel to the polarization direction of the incident light.

4. The method of any one of claims 1 to 3, wherein the incident light of the second exposure process is visible light or ultraviolet rays.

5. The method of any one of claims 1 to 4, wherein the performing of the second exposure process comprises irradiating the photoresist patterns with the incident light using a laser.

6. The method of any one of claims 1 to 5, wherein the polymer contains a repeating unit represented by Formula 1: 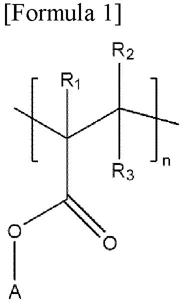
wherein in Formula 1, R1, R2, and R3 are each independently hydrogen or an alkyl group having 1 to 10 carbon atoms, A is a functional group represented by Formula 2, and n is an integer of 2 to 10,000, 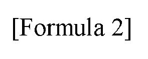 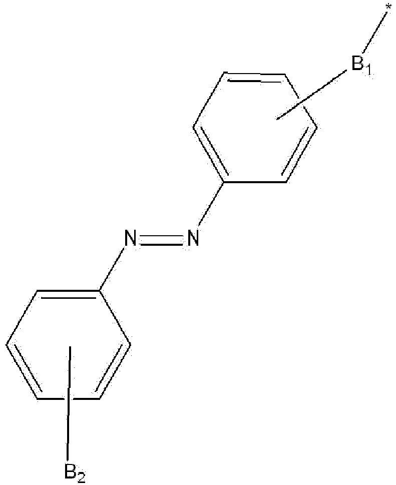
wherein in Formula 2, B1 is a linking group represented by Formula 3, Formula 4, or Formula 5, B2 is hydrogen, a halogen group, an alkyl group having 1 to 10 carbon atoms, -OH, -COOH, or -NO₂, and * is a portion bonded to oxygen in Formula 1, 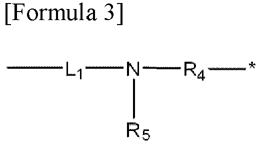 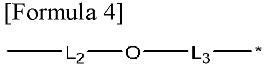 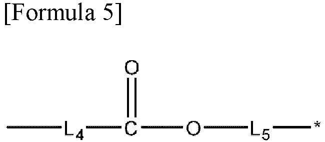
wherein in Formulas 3 to 5, L1, L2, L3, L4, and L5 are each independently a single bond or an alkylene group having 1 to 10 carbon atoms, and * is a portion bonded to oxygen in Formula 1, and
wherein in Formula 3, R4 is an alkylene group having 1 to 10 carbon atoms, R5 is hydrogen, an alkyl group having 1 to 10 carbon atoms, -CₓH₂ₓ-CN, -CₓH₂ₓ-OH, or -CₓH₂ₓ-ORa, wherein x is an integer of 1 to 10, and Ra is an alkyl group having 1 to 10 carbon atoms.

7. The method of any one of claims 1 to 6, wherein the photoresist film comprises a tin oxide nanocluster having the azobenzene group.

8. The method of any one of claims 1 to 7, wherein the metal oxide nanocluster is represented by Formula 7:
[Formula 7] [(R-M)₁₂O₁₄(OH)₆]²⁺[Rx⁻]₂
wherein in Formula 7, M is a metal, at least one selected from the group consisting of tin (Sn), zinc (Zn), lithium (Li), sodium (Na), potassium (K), beryllium (Be), magnesium (Mg), calcium (Ca), barium (Ba), aluminum (Al), silicon (Si), cadmium (Cd), mercury (Hg), chromium (Cr), iron (Fe), cobalt (Co), nickel (Ni), copper (Cu), germanium (Ge), palladium (PD), platinum (Pt), lead (Pb), strontium (Sr), and manganese (Mn), R is an alkyl group having 1 to 20 carbon atoms, and Rx⁻ is a counter anion represented by Formula 8: 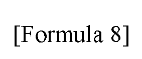 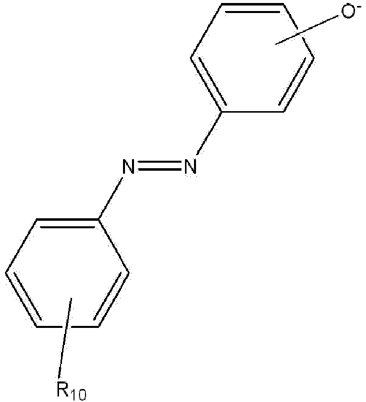
wherein in Formula 8, R10 is -H, -OH, -COOH, an alkyl group having 1 to 10 carbon atoms, or a halogen group.

9. The method of any one of claims 1 to 8, wherein the first exposure process is performed using ultraviolet rays, deep ultraviolet rays, extreme ultraviolet rays, or electron beams.

10. The method of any one of claims 1 to 9, wherein the photoresist film comprises an exposed portion and an unexposed portion by the first exposure process, and
the forming of the photoresist patterns comprises removing the exposed portion or the unexposed portion of the photoresist film through the development process.

11. A resist composition for photolithography comprising a metal oxide nanocluster having an azobenzene group.

12. The resist composition for photolithography of claim 11, wherein the metal oxide nanocluster is represented by Formula 7:
[Formula 7] [(R-M)₁₂O₁₄(OH)₆]²⁺[Rx⁻]₂
wherein in Formula 7, M is a metal, at least one selected from the group consisting of tin (Sn), zinc (Zn), lithium (Li), sodium (Na), potassium (K), beryllium (Be), magnesium (Mg), calcium (Ca), barium (Ba), aluminum (Al), silicon (Si), cadmium (Cd), mercury (Hg), chromium (Cr), iron (Fe), cobalt (Co), nickel (Ni), copper (Cu), germanium (Ge), palladium (PD), platinum (Pt), lead (Pb), strontium (Sr), and manganese (Mn), R is an alkyl group having 1 to 20 carbon atoms, and Rx⁻ is a counter anion represented by Formula 8: 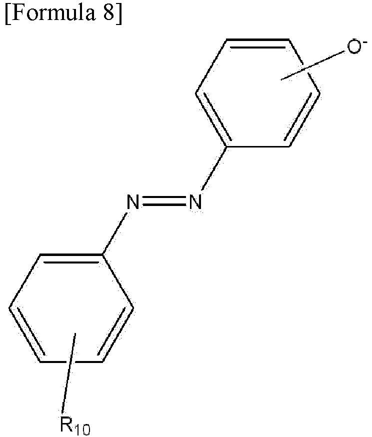
wherein in Formula 8, R10 is -H, -OH, -COOH, an alkyl group having 1 to 10 carbon atoms, or a halogen group.

13. The resist composition for photolithography of claim 12, wherein in Formula 7, Rx⁻ is a counter anion represented by Formula 8-1:

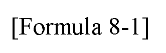

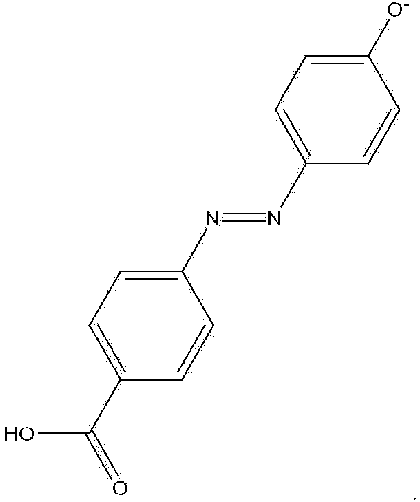

14. The resist composition for photolithography of claim 12 or claim 13, wherein in Formula 7, M is tin.
